# EUROPEAN PATENT APPLICATION

(11) **EP 4 625 473 A1**
(43) Date of publication of application: **01.10.2025**
(21) Application number: 24209723.6
(22) Date of filing: 30.10.2024
(51) Int. Cl.: H01L 21/306

(54) **METHOD OF ETCHING**

(30) Priority: 27.03.2024 GB 202404375
(71) Applicant: SPTS Technologies Limited, Newport Gwent NP18 2TA (GB)
(72) Inventor: ASHRAF, Huma, Newport (GB); BURNETT, Jay Leslie, Newport (GB)
(74) Representative: Wynne-Jones IP Limited

(57) **Abstract**

According to the invention there is provided method of plasma etching a substrate comprising at least one GaN or GaN alloy layer to form a feature, the method comprising the steps of:
(a) providing a substrate with a mask formed thereon, the mask having an opening, wherein the substrate comprises at least one GaN or GaN layer; and
(b) performing a plasma etch step using an inductively coupled plasma (ICP) etch apparatus to anisotropically etch the at least one GaN or GaN alloy layer through the opening to produce a feature having one or more side walls and a bottom surface, the ICP etch apparatus comprising an ICP coil and an RF supply which supplies an RF electrical signal to the ICP coil;
wherein the plasma etch step uses an etch recipe consisting essentially of Cl₂ and Argon and the RF electrical signal has an associated RF power in the range 100 to 300W.

## Description

### Field of the Disclosure

This invention relates to a method of etching a substrate, with particular reference to plasma etching a substrate comprising at least one GaN or GaN alloy layer to form a feature. The invention relates also to an associated apparatus for plasma etching a substrate, and to a substrate comprising at least one GaN or GaN alloy layer having a feature formed therein.

### Background of the Disclosure

Gallium nitride (GaN) is increasingly used as a wide-band gap, high charge mobility and relatively low dielectric constant material for power semiconductor devices, particularly as a gate trench in MOSFET devices. Such properties can be exploited in a wide range of devices and applications. For example, transistors with fast switching speeds and low losses can be provided, as well as power converters with high power densities. Other areas of applications include: technologies for fast charging electric vehicles through compact OBCs (onboard chargers) and HV DC-DC with twice the power density of alternative materials; high efficiency and diverse LED applications; always-on energy intensive data centres with improved efficiencies; high power density converters for photovoltaic harvesting and storage; and consumer electronics with greater power densities such as next generation chargers, PC DC-DC converters, and others. Dry etched gallium nitride trenches with a typical width of 1-5µm and a typical depth of 1-3µm are well suited to such uses.

In a typical GaN power device, such as a MOSFET device, the gate trench acts to control the width of the depletion region, and therefore controls the conductivity of the channel between the source and drain. The exact shape of the gate etch itself is important for numerous reasons relating to device operation (penetrating deep enough into drift region, sufficient sidewall profile angle for good dielectric deposition coverage etc.) and, importantly for the purposes of this application, the minimisation of charge leakage. Such leakage occurs as a result of a build up of charge, often at the etched trench corners, giving rise to a large electric field gradient across the channel-dielectric-metal interface. When the resulting potential difference is greater than the metal-insulator-semiconductor Schottky barrier height of the interface, charge leakage occurs. This causes a reduction in breakdown voltage, which limits the maximum rectifying power of the device. First generation GaN devices with a breakdown voltage of about 100V are already established and commercially available, whilst 600/650V platforms are currently of industrial interest. However, global demand for devices exceeding 1200V is increasing. Such devices, often of a vertical architecture, experience additional charge losses, making the minimisation of charge leakage ever more significant. Hence, trench formation is predicted to play an ever-important role in the realisation of high-breakdown-voltage GaN transistors.

Currently, industry is focused on reducing charge leakage via the reduction of micro-trenching at the trench corners Micro-trenching is a well known phenomenon whereby ion deflections, nuances of etch mechanism, species transport and consumption at etch front along with ion energy and wafer-level current density considerations cause an elevated etch rate at the trench corners relative to the trench centre, inducing triangular shaped points. Such points act as a source of significant charge build-up and charge leakage. Despite it being possible to successfully fabricate flat based trenches, the breakdown voltage is still restricted by the discontinuous nature of flat trench corners. Consequently, there is growing demand from industry and literature for dry etch solutions that produce rounded corners in GaN trenches.

### Statement of Invention

The present invention, in at least some of its embodiments, addresses the above-described problems, desires and requirements. In particular, the present invention, in at least some of its embodiments, proposes an industry scalable dry plasma etch solution for GaN, which allows a flat-bottomed feature such as a trench to be achieved in situ by dry etching, thereby reducing micro-trenching. The invention is also applicable to the etching of GaN alloys such as AlGaN and In GaN.

According to a first aspect of the invention there is provided a method of plasma etching a substrate comprising at least one GaN or GaN alloy layer to form a feature, the method comprising the steps of:
(a) providing a substrate with a mask formed thereon, the mask having an opening, wherein the substrate comprises at least one GaN or GaN layer; and
(b) performing a plasma etch step using an inductively coupled plasma (ICP) etch apparatus to anisotropically etch the at least one GaN or GaN alloy layer through the opening to produce a feature having one or more side walls and a bottom surface, the ICP etch apparatus comprising an ICP coil and an RF supply which supplies an RF electrical signal to the ICP coil;
wherein the plasma etch step uses an etch recipe consisting essentially of Cl₂ and Argon and the RF electrical signal has an associated RF power in the range 100 to 300W.

The bottom surface of the feature produced by the plasma etch step can be substantially flat. It is desirable to produce a substantially flat bottom surface. In this way, micro-trenching at trench corners can be reduced or even avoided. In this way, an etch process of the invention can be used as a gate etch method in the production of a device such as a vertical or semi-vertical MOSFET device to provide substantially reduced off-state leakage.

The Cl₂ and Argon can be introduced to the ICP etch apparatus with associated flow rates in sccm. The ratio of the Argon to Clz flow rates can be in the range 1.25:1 to 2.75:1. The ratio of the Argon to Clz flow rates can be in the range 1.75:1 to 2.25:1. The ratio of the Argon to Clz flow rates can be about 2.0:1.

The flow rate of Cl₂ can be in the range 30 to 75 sccm.

The flow rate of Argon can be in the range 75 to 150 sccm.

The plasma etch step can use an etch recipe consisting of Clz and Argon.

The ICP etch apparatus can further comprise a substrate support and a power supply for supplying a bias electrical signal having an associated bias power to the substrate support. The bias power can be in the range 300 to 475 W for a 200mm diameter substrate or 675 to 1070 W for a 300mm diameter substrate.

The plasma etch step can be performed with an etch recipe having an associated pressure in the range 1 to 5 mTorr.

The feature can be a trench. The feature can be a via.

The feature may be substantially free of micro-trenches or may have relatively shallow micro-trenches. The feature can comprise micro-trenches each having a depth which is 2% or less of the depth of the feature and/or a depth which is less than 30nm. Micro-trenches are understood to be pointed etch sub-features in the corners of the feature which have a depth greater than the depth of the central region of the bottom surface of the feature. Typically, micro-trenches have a substantially triangular cross sectional appearance.

The central region of the bottom surface of the fully formed feature can be substantially flat. The edge region can form a rounded corner between the central region of the bottom surface and a side wall of the fully formed feature.

It is possible for the plasma etch step to be the only significant plasma etch step employed. In this case, the plasma etch step can produce a fully formed feature.

Alternatively, the plasma etch step can produce a feature which is partially formed. One or more further etch steps can be employed to produce a fully formed feature. The one or more further etch steps can be plasma etch steps. Accordingly, the method can further comprise a step (c) of performing a second plasma etch step to produce a fully etched feature. The second plasma etch step can be performed to produce a fully etched feature having a bottom surface which curves upwards to meet one or more side walls. The plasma etch step can be performed to produce a partially formed feature having a depth which is between 60 to 80% of the depth of the fully formed feature. In principle, the one or more further etch steps can comprise a wet etch step, although this is less desirable in comparison to processes which only use dry etching steps.

The mask can be of any suitable type. The mask can be a photoresist mask. The mask can be a hard mask, such as a SiOz hard mask.

The fully formed feature can have a depth in the range 1.0 to 3.0 microns. The fully formed feature can have a depth in the range 1.0 to 5.0 microns.

The method can further comprise selectively removing the mask from the substrate after performing the plasma etch step. Any suitable removal technique can be used.

The GaN or GaN alloy can be present as a single layer or as more than one layer, for example in a stack of layers. Different GaN or GaN alloy layers can be provided with different degrees of doping.

The substrate can comprise additional layers. For example, the substrate can comprise one or more dielectric layers. A dielectric layer can be located directly underneath the mask. The dielectric layer can be silicon dioxide. The substrate can comprise a support layer underneath a GaN or GaN alloy layer. The support layer can be formed of a material such as AIN that aids epitaxial growth of a GaN or GaN alloy. In practice, it is common for the GaN layers to be epitaxially deposited on a Si base layer with a transition layer such as AIN to aid growth of the epi GaN. However alternative base layers can be used, such as sapphire, SiC or GaN.

According to a second aspect of the invention there is provided a substrate comprising at least one GaN or GaN alloy layer having a feature formed using the method according to the first aspect of the invention. The feature can have a bottom surface which curves upwards to meet one or more side walls. Alternatively, the feature can have a substantially flat bottom surface.

The feature can be a trench. The feature can be a via.

According to a third aspect of the invention there is provided an inductively coupled plasma (ICP) etch apparatus for plasma etching a substrate comprising at least one GaN or GaN alloy layer to form a feature using the method according to the first aspect of the invention, the apparatus comprising:
a chamber;
a substrate support disposed within the chamber for supporting a substrate thereon;
at least one gas inlet for introducing an etch recipe consisting essentially of Cl₂ and Argon into the chamber;
an ICP plasma generation device for sustaining a plasma in the chamber comprising an ICP coil and an RF supply which supplies an RF electrical signal to the ICP coil;
a power supply for supplying a bias electrical signal having an associated bias power to the substrate support; and
a controller configured to control the RF supply so that an RF electrical signal having an associated RF power in the range 100 to 300W is supplied to the ICP coil during the plasma etching of the substrate.

For the avoidance of doubt, whenever reference is made herein to 'comprising' or 'including' and like terms, the invention is also understood to include more limiting terms such as 'consisting' and 'consisting essentially'.

Whilst the invention has been described above, it extends to any inventive combination of the features set out above, or in the following description, drawings or claims. Any features disclosed in relation to one of the first, second and third aspects of the invention may be combined with any features disclosed in relation to another aspect of the invention as appropriate.

### Description of the Drawings

Embodiments of the invention will now be described, by way of example only, with reference to the accompanying drawings, in which:
Figure 1 is a cross-sectional semi-schematic view of stages in a GaN trench etching process, wherein (a) is prior to commencement of the etch process, (b) is after a first plasma etch step to produce a trench with a flat base, and (c) is after an optional second plasma etch step;
Figure 2 is a cross-sectional schematic view of a plasma etch apparatus suitable for performing the invention;
Figure 3 shows micro-trenching as a function of source power;
Figure 4 shows micro-trenching as a function of bias power; and
Figure 5 shows micro-trenching as a function of Ar:Cl₂ gas ratio.

### Detailed Description of the Disclosure

The invention provides a plasma etch process for etching GaN or a GaN alloy to produce an etched feature. The invention comprises an anisotropic plasma etch step using an etch recipe consisting essentially of Cl₂ and Argon. This etch step is a `bulk' or 'main' etch which etches the majority of the depth of the feature or the entire depth of the feature. The plasma etch step is performed using an inductively coupled plasma (ICP) etch apparatus to anisotropically etch the at least one GaN or GaN alloy layer through an opening in a mask to produce a feature having one or more side walls and a bottom surface. The ICP etch apparatus comprises an ICP coil and an RF supply which supplies an RF electrical signal to the ICP coil with an associated RF power in the range 100 to 300W. Optionally, one or more further etch steps can be performed to produce a fully formed feature having desired characteristics, for example a feature with rounded bottom corners.

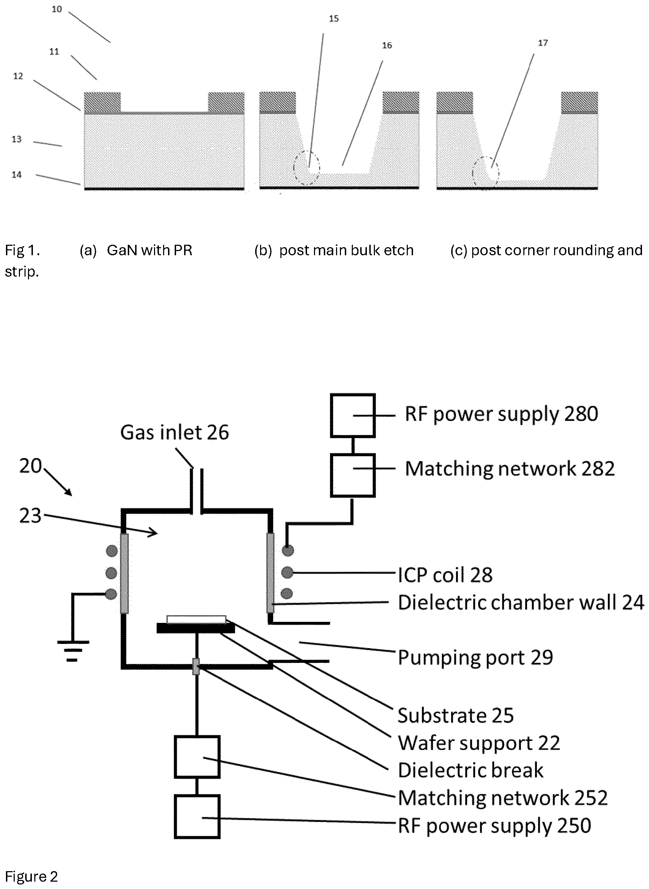

Figure 1 shows stages in a simplified process flow in which a substrate 10 undergoes etching. Figure 1 (a) shows the substrate prior to commencement of the etching process. The substrate 10 comprises a GaN device layer or layers 13, optionally with additional thin dielectric layers12 such as SiOz located on the GaN layer 13. A mask 11 is formed on an upper surface of the substrate 10. Instead of a single layer of GaN, a number of layers of GaN may be present. The substrate 10 can further comprise one or more additional, base layers 14, such as an AIN layer, located beneath the epitaxial layers of GaN. The additional layer 14 aids the epitaxial growth process. A main, anisotropic plasma etch step of the GaN layer 13 is performed to etch a trench having a flat base as shown in Figure 1 (b). The plasma etch step can be preceded by one or more initial etch steps to open the layers 12 if present in the substrate 10. Optionally, a second etch step can be performed to produce rounded or otherwise curved corners while simultaneously slightly extending the depth of the feature. Figure 1 (c) shows the fully formed trench following a second plasma etch step and a plasma strip process to remove passivation material deposited during the second plasma etch step. The rounded corners 17 can be seen. An example of a suitable second etch step is described in the Applicant's co-pending UK patent application entitled 'Method and apparatus for plasma etching a substrate' and filed on the same date as the present application.

Figure 2 shows a schematic representation of a plasma etch apparatus 20 suitable for performing the present invention. Plasma etching of the substrate is typically performed using a plasma etch apparatus. The plasma etch apparatus can be an inductively coupled plasma (ICP) apparatus such as the Omega Synapse^{™} tool available from SPTS Technologies Limited of Newport, UK. However, etching can also be performed using other dry etch systems, such as helicon, RIE or microwave type apparatus. The generation of a plasma within such plasma etch apparatus is well-known in the art and will not be described here other than where necessary for an understanding of the present invention.

A plasma etch apparatus 20 shown in Figure 2 is an ICP apparatus which typically comprises a substrate support (or platen) 22 disposed within a chamber 23 for supporting the substrate 25. A bias power can be supplied to the substrate by a RF power supply 250 via an impedance matching network 252. The chamber can comprise a chamber wall having a dielectric part 24. Cl₂ and Argon process gases can be introduced into the chamber via one or more gas inlets 26. An ICP plasma generating device 28 can be used to generate and sustain a plasma within the chamber 23 as is known in the art (e.g. using a RF power supply 280 and impedance matching network 282). The gases can be removed from the chamber 23 via a pumping port 29.

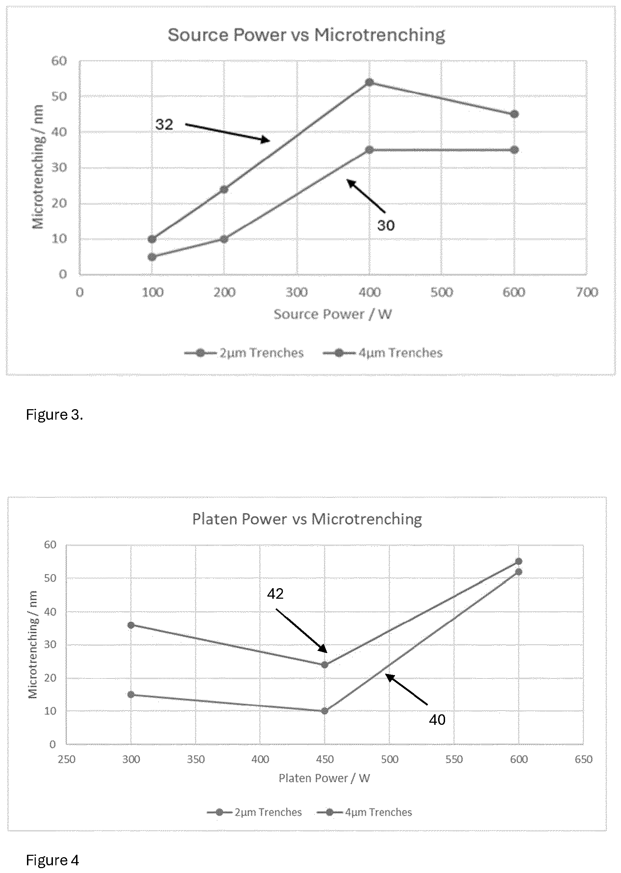

The plasma etch step will now be described in more detail. The invention utilises conditions which are designed to maintain a flat etch front with minimal micro-trenching. Achieving such an etch front requires the compensation of a variable etch rate across the trench base via careful balancing of incident ion current density, average ion bombardment energy combined with an appropriate concentration and ratio of etchant species and ions at a given pressure. In other words, it is non-trivial to achieve a flat etch front. GaN etching is a strong function of bias, where etch rates can vary substantially, rather than of plasma density, which has more limited influence over etch rate. In the present invention, minimal source powers are used. Without wishing to be bound by any particular theory or conjecture, it is believed that the observed benefit to micro-trenching may be due to etching taking place with an enhanced RIE (reactive ion etching) mode in comparison to ICP character. Experiments were performed to investigate the optimal conditions for achieving a flat etch front. Representative results and conclusions are described below in relation to Figures 3 to 5. Micro-trench dimensions were established from SEM cross section measurements.

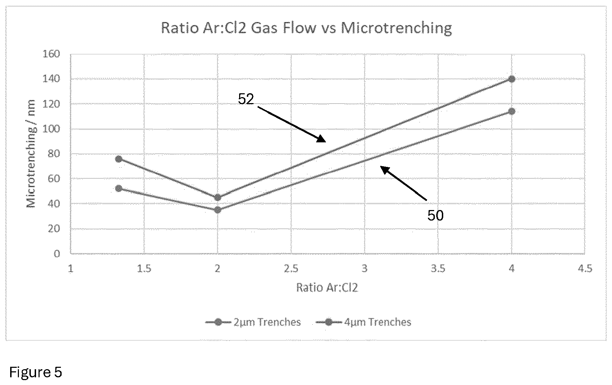

Figure 3 shows micro-trenching as a function of source power to the ICP coil when etching a 2 micron trench 30 and a 4 micron trench 32. The optimal source power appears to tend to zero. The results were obtained using the following conditions: 3mTorr pressure, 450W platen power, 100:50sccm (Ar:Cl₂), 20°C platen temperature. Figure 4 shows micro-trenching as a function of platen power when etching a 2 micron trench 40 and a 4 micron trench 42. The results were obtained using the following conditions: 3mTorr pressure, 200W source power, 100:50sccm(Ar:Cl₂), 20°C platen temperature. At a given optimised source power (which is linked to incident ion current density), there exists an optimal platen power (which is linked to average ion bombardment energy), which was determined to be 450W, at 200W source power, as seen in Figure 4. Additionally, there exists an optimal flow rate of gases along with an optimal ratio. It is believed that there is an optimal ratio of etchants to ions which is required to compensate for etch rate variability across the etch front. Should the total flow rate be too high for a given set of conditions, micro-trenching increases; should it be too low, etch rate suffers and there is an insufficient density of active species to remove sidewall striations. A practical range of flow rates for the features being etch was considered to be 30-75sccm Cl₂ and 75-150 sccm Ar. Figure 5 shows micro-trenching as a function of Ar:Cl₂ gas flow ratio (gas flows in sccm) when etching a 2 micron trench 50 and a 4 micron trench 52. The results were obtained using the following conditions: 3mTorr pressure, 600W source power, 450W platen power, 20°C platen temperature. The optimal gas flow ratio was found to be about 2:1 (Ar:Cl₂).

The result of such optimisation is a process that repeatably minimises micro-trenching to less than 10nm on each side of a 2µm trench when etching GaN. It is noted that some variation in the process parameters away from their completely optimised values is possible while still providing excellent reductions in the amount of micro-trenching. In other words, the invention provides ranges of parameters which still provide desirable results. Additionally, the optimal values of the process parameters will depend to some extent on the precise etching scenario. For example, for a higher open area of material exposed by the mask, it is expected that the total gas flow may need to be increased somewhat to account for a greater rate of consumption of species at the wafer level. It would then be expected that the optimal parameter values for micro-trench minimisation would vary somewhat, although not substantially. The ranges provided by the present invention accommodate such variations.

### Example

Experimental work was carried out on epitaxial GaN layers on 200mm silicon wafers with a photoresist mask (3µm) and 2-4µm CDs. Trench depth was nominally about 1.5-2µm. An Omega Synapse^{™} ICP etch tool (SPTS Technologies Limited of Newport, UK) was used to perform a first and a second plasma etch step. A flat based trench as generally show in in Figure 1 (b) was achieved using the first plasma etch step with the conditions shown in Table 1.

**Table 1. First plasma etch step process parameters.**

| **Parameter** | **Value** |
|---|---|
| Chamber Pressure (mTorr) | 3 |
| Source Power (W) | 200 |
| Platen Power (W) | 450 |
| ESC Temperature (°C) | 20 |
| Chlorine (sccm) | 50 |
| Argon (sccm) | 100 |

In this example, a second plasma etch step was performed followed by a passivation material strip step. The resulting trenches were found to have excellent profiles with flat central regions and rounded edge regions with no discontinuities between the regions. It will be appreciated that the process might instead use a first plasma etch only to produce a flat based trench.

## Claims

1. A method of plasma etching a substrate comprising at least one GaN or GaN alloy layer to form a feature, the method comprising the steps of:
(a) providing a substrate with a mask formed thereon, the mask having an opening, wherein the substrate comprises at least one GaN or GaN layer; and
(b) performing a plasma etch step using an inductively coupled plasma (ICP) etch apparatus to anisotropically etch the at least one GaN or GaN alloy layer through the opening to produce a feature having one or more side walls and a bottom surface, the ICP etch apparatus comprising an ICP coil and an RF supply which supplies an RF electrical signal to the ICP coil;
wherein the plasma etch step uses an etch recipe consisting essentially of Cl₂ and Argon and the RF electrical signal has an associated RF power in the range 100 to 300W.

2. A method according to claim 1, wherein Cl₂ and Argon are introduced to the ICP etch apparatus with associated flow rates in sccm and the ratio of the Argon to Cl₂ flow rates is in the range 1.25:1 to 2.75:1.

3. A method according to claim 2, wherein the ratio of the Argon to Clz flow rates is in the range 1.75:1 to 2.25:1, preferably about 2.0:1.

4. A method according to any one of claims 1 to 3, wherein the ICP etch apparatus further comprises a substrate support and a power supply for supplying a bias electrical signal having an associated bias power to the substrate support, and the bias power is in the range 300 to 475 W for a 200mm diameter substrate or 675 to 1070 W for a 300mm diameter substrate.

5. A method according to any previous claim wherein the plasma etch step is performed with an etch recipe having an associated pressure in the range 1 to 5 mTorr.

6. A method according to any previous claim, wherein the Clz is introduced to the ICP etch apparatus with an associated flow rate in the range 30 to 75 sccm.

7. A method according to any previous claim, wherein the Ar is introduced to the ICP etch apparatus with an associated flow rate in the range 75 to 150 sccm.

8. A method according to any previous claim, wherein the feature is a trench.

9. A method according to any previous claim, wherein the feature comprises micro-trenches each having a depth which is 2% or less of the depth of the feature and/or a depth which is less than 30nm.

10. A method according to any previous claim, wherein the bottom surface of the feature produced by the plasma etch step is substantially flat.

11. A method according to any previous claims, further comprising a step (c) of performing a second plasma etch step to produce a fully etched feature.

12. A method according to claim 9, wherein the second plasma etch step is performed to produce a fully etched feature having a bottom surface which curves upwards to meet one or more side walls.

13. A method according to any previous claim, wherein the mask is a photoresist mask or a hard mask.

14. A substrate comprising at least one GaN or GaN alloy layer having a feature at least partially produced using the method according to claim 1.

15. An inductively coupled plasma (ICP) etch apparatus for plasma etching a substrate comprising at least one GaN or GaN alloy layer to form a feature using the method according to claim 1, the apparatus comprising:
a chamber;
a substrate support disposed within the chamber for supporting a substrate thereon;
at least one gas inlet for introducing an etch recipe consisting essentially of Cl₂ and Argon into the chamber;
an ICP plasma generation device for sustaining a plasma in the chamber comprising an ICP coil and an RF supply which supplies an RF electrical signal to the ICP coil;
a power supply for supplying a bias electrical signal having an associated bias power to the substrate support; and
a controller configured to control the RF supply so that an RF electrical signal having an associated RF power in the range 100 to 300W is supplied to the ICP coil during the plasma etching of the substrate.
